# EUROPÄISCHE PATENTSCHRIFT

(11) **EP 4 639 621 B1**
(45) Veröffentlichungstag und Bekanntmachung des Hinweises auf die Patenterteilung: **11.11.2026**
(21) Anmeldenummer: 24707433.9
(22) Anmeldetag: 06.02.2024
(51) Int. Cl.: H02M 7/00, H10W 40/30, H10W 72/00, H10W 90/00

(54) **LEISTUNGSHALBLEITERMODUL MIT DRUCKKONTAKTIERUNGEN**
POWER SEMICONDUCTOR MODULE WITH PRESSURE CONTACTS
MODULE SEMI-CONDUCTEUR DE PUISSANCE DOTÉ DE CONTACTS À PRESSION

(30) Priorität: 07.02.2023 EP 23155400
(43) Veröffentlichungstag der Anmeldung: 29.10.2025
(73) Patentinhaber: Siemens Aktiengesellschaft, 80333 München (DE)
(72) Erfinder: KRIEGEL, Kai, 81739 München (DE); MITIC, Gerhard, 81827 München (DE); NEUGEBAUER, Stephan, 91058 Erlangen (DE); RAAB, Oliver, 94496 Ortenburg (DE); RADÜGE, Christian, 90587 Obermichelbach (DE); STEGMEIER, Stefan, 81825 München (DE); WAGNER, Claus Florian, 90425 Nürnberg (DE); WOITON, Michael, 90425 Nürnberg (DE)
(74) Vertreter: Siemens Patent Attorneys
(86) Internationale Anmeldenummer: PCT/EP2024/052913
(87) Internationale Veröffentlichungsnummer: WO 2024/165559

(56) Entgegenhaltungen:
- EP-A1- 2 665 095
- JP-A- S5 068 476
- JP-A- S5 079 272
- US-A- 3 972 063
- US-A1- 2020 084 914

## Beschreibung

Die vorliegende Erfindung betrifft ein Leistungshalbleitermodul mit Druckkontaktierungen sowie einen Stromrichter mit zumindest einem derartigen Leistungshalbleitermodul.

Umwelttechnische Designaspekte und Produktrealisierungen gewinnen auch in der Elektronik immer mehr an Bedeutung. Schrittweise wird versucht mehr Elemente des sogenannten Eco-Designs in den Produkten zu implementieren. Speziell im Bereich der Leistungselektronik, die getrieben wird durch die Elektromobilität, aber auch durch wirtschaftlich wichtige Bereiche der Industrieantriebe und Energieumwandlung, gewinnt Eco-Design zunehmend an wirtschaftlicher und umwelttechnischer Bedeutung.

Insbesondere in einem speziellen Bereich der Leistungselektronik, bei den Leistungsmodulen, wird durch das zyklische Ein- und Ausschalten von Halbleiterbausteinen (z.B. Transistoren, Thyristoren) eine Spannungs-, Strom- oder Frequenzumwandlung durchgeführt, um z.B. einen Motor antreiben zu können. Betrachtet man die Module aus dem Blickwinkel der Rezyklierbarkeit, bzw. der Umweltfreundlichkeit im Allgemeinen, findet man diverse problematische Eigenschaften und Materialien innerhalb der Leistungsmodule.

Üblicherweise wird beim Eco-Design darauf verzichtet stoffschlüssige, nicht-trennbare und energieintensive Verbindungen und Materialien zu verwenden. Dies war im Bereich der Leistungselektronik auf Grund der wichtigen Funktionen der Teilelemente und den immensen Anforderungen an hohe elektrische Isolation, gutes thermisches Management sowie hohe Zuverlässigkeit bisher nicht einfach möglich.

Einen ersten Ansatz hierfür verfolgt beispielsweise die sogenannte SharC-Technologie, wie in der WO2021254679A1 beschrieben oder auch der Weg über angedrückte Leadframes, wie in der DE102016217007A1 offenbart.

Dabei wird mit Hilfe von Druckkontakten eine elektrisch leitfähige Verbindung erzeugt. Diese Verbindung ist im Recycling- oder Reparaturfall wieder lösbar. Durch die in der Leistungselektronik fließenden hohen Ströme und den daher notwendigen niedrigen Kontaktwiderständen, müssen hohe Druckkräfte an den Kontakten aufgebracht werden. Dazu besteht die chipunterseitige Verbindung üblicherweise weiterhin aus einer stoffschlüssigen Lot- oder Sinterverbindung, damit eine gute Kühlung der Chips bzw. der Leistungsmodule gewährleistet werden kann. Und der beschriebene bekannte Aufbau nutzt daneben dennoch weiterhin eine Vergussmasse aus isolierendem Silicon-Gel, um die elektrische Isolation zu gewährleisten.

Folglich stellt es sich als technisch erforderlich dar, eine verbesserte Lösung vorzuschlagen, welche die aus dem Stand der Technik bekannten Nachteile vermeidet. Insbesondere soll die vorzuschlagende Lösung eine lösbare Druckkontaktierung ermöglichen, bei gleichzeitig effizienter Kühlbarkeit des Leistungshalbleiters.

Diese der vorliegenden Erfindung zugrunde liegenden Aufgaben werden durch ein Leistungshalbleitermodul gemäß dem Patentanspruch 1 gelöst. Vorteilhafte Ausgestaltungen der Erfindung sind Gegenstand der Unteransprüche.

### Beschreibung der Erfindung

Das erfindungsgemäße Leistungshalbleitermodul weist wenigstens ein Leistungshalbleiterelement in einem Gehäuse auf, wobei das Gehäuse wenigstens ein flüssiges Kühlmedium beinhaltet. Das Leistungshalbleitermodul steht über das Kühlmedium in thermisch leitfähiger Verbindung mit dem Gehäuse, und das Kühlmedium umfasst insbesondere eine dielektrische Flüssigkeit ist. Bevorzugt wird als Kühlmedium eine chemisch inerte Flüssigkeit eingesetzt, welche zweckdienlicherweise zumindest gegenüber verbauten Materialien chemisch inert ist. Das Leistungshalbleitermodul umfasst des Weiteren Druckkontaktierungen für das wenigstens eine Leistungshalbleiterelement, welche mittels wenigstens einer Andrückvorrichtung an das wenigstens eine Halbleiterelement angedrückt wird, so dass ein elektrischer Kontakt hergestellt ist. Insbesondere werden die Druckkontaktierungen über das Gehäuse an das wenigstens eine Halbleiterelement angedrückt. Das Gehäuse übt somit eine mechanische Kraft auf die wenigstens eine Andrückvorrichtung aus. Insbesondere wird über den Gehäuseschluss eine mechanische Kraft auf die Andrückvorrichtung und damit auf die Druckkontaktierungen ausgeübt. Alternativ kann ein Druckmechanismus vorhanden sein, der unabhängig vom Gehäuseschluss aktiviert werden kann, z.B. ein Schraubmechanismus. Die abzuführende Wärme kann durch Wärmeleitung nach außen abgegeben werden.

Die Druckkontaktierungen haben beispielsweise unter anderem den Vorteil, dass damit herkömmliche Drahtbonds vermieden werden.

In einer besonders zweckdienlichen Ausführungsform der Erfindung weist das Gehäuse des Leistungshalbleitermoduls wenigstens ein Kühlelement auf, über welches die Wärme an eine Wärmesenke abgegeben wird. Dieses wenigstens eine Kühlelement und das Kühlmedium stehen insbesondere in einer elektrisch isolierenden und thermisch leitfähigen Verbindung, beispielsweise über das Gehäuse.

In einer weiteren Ausführungsform der Erfindung können inerte Kühlflüssigkeit und Gehäuse gegeneinander elektrisch isoliert sein. Alternativ können sie auch auf Potential liegen, welches dann von den anderen Potentialen isoliert ist.

Bei herkömmlichen Drahtbond-Leistungsmodulen mit Bodenplatte wird insbesondere in einem ersten Produktionsschritt eine stoffschlüssige Lotverbindung zwischen einem Halbleiter-Chip und einem Schaltungsträger erzeugt, welcher meist eine sogenannte DCB, eine Direct-Copper-Bond Keramik ist. Die Produktion der Keramik an sich ist schon sehr energieaufwendig, einerseits das Sintern der Keramik selbst bei über 1500°C, und anderseits das Aufbringen der elektrisch-leitfähigen Kupferlagen. Diese beiden Kupferlagen werden stoffschlüssig mit der Ober- und Unterseite der Keramik verbunden. Die Verbindung der Kupferlagen mit der Keramik wird unter hohem Energieeinsatz bei 1065°C erzeugt.

Ein derartig energieintensiver Herstellungsschritt wird demnach bei dem erfindungsgemäßen Leistungsmodul vermieden. Eine isolierende Keramik wird überflüssig, da die elektrische Isolation mittels der dielektrischen Flüssigkeit bewirkt wird.

Zudem wird im Stand der Technik nach der Chiplötung eine sogenannte Systemlötung durchgeführt. Bei dieser wird der Verbund aus Chip und DCB wiederum stoffschlüssig auf eine relativ dicke metallbasierte Bodenplatte gelötet. Im nächsten Schritt erfolgt die oberseitige Ankontaktierung der Chips mit Hilfe einer Vielzahl von Drahtbonds, welche an die Chipmetallisierung und den entsprechenden Gegenkontakt auf der DCB sozusagen mikroverschweißt werden. Ein weiterer Vorteil des erfindungsgemäßen Leistungshalbleitermoduls liegt also darin, dass auch eine Vielzahl an stoffschlüssigen Verbindungen vermieden wird. Das hiermit vorgeschlagene recyclierbare Halbleitermodul kommt demnach ohne nicht- oder schwer-auftrennbare Stoffverbindungen aus.

Ein weiterer Vorteil wird beispielsweise durch das Kühlmedium begünstigt: Bei dem vorgeschlagenen Leistungshalbleiterbauteil wird darauf verzichtet die gesamte Schaltung mit Silicon-Gel zu verkapseln, da das Kühlmedium gleichermaßen auch elektrisch isolierend wirkt. Auch ein Verkleben eines im Stand der Technik üblichen Plastikgehäuses mit der Bodenplatte wird vermieden, da das Gehäuse z.B. zweckdienlicherweise eine Dichtung anstelle einer Verklebung aufweist.

Unter einem Leistungshalbleitermodul im Kontext dieser Patentanmeldung wird ein Leistungshalbleiterbauteil verstanden, in welchem mittels zyklischem Ein- und Ausschalten von Halbleiterbausteinen, wie z.B. Transistoren oder Thyristoren, eine Spannungs- , Strom- oder Frequenzumwandlung durchgeführt wird. Beispielsweise wird diese Frequenzumwandlung zum Antreiben eines Motors genutzt.

Leistungsmodule können insbesondere Leistungshalbleiterzellen sein, welche beispielsweise, in einer modularen Anordnung von mehreren Leistungsmodulzellen, einen in seiner Leistung skalierbaren Umrichter bilden können.

Leistungshalbleiterelemente können beispielsweise sein, Schaltelemente, z.B. Dioden in Gleichrichtern, Thyristoren, z.B. zum Schalten, Steuern und Regeln, insbesondere aufweisend eine Steuerelektrode, Triacs, z.B. zum Schalten von Wechselströmen, Transistoren, z.B. (Leistungs-) MOSFETs oder IGBTs.

Das Halbleiterelement, insbesondere Leistungshalbleiterelement, ist zweckdienlicherweise ein Halbleiterchip. Der Halbleiterchip wird dabei als nicht eingehauster Die (bare-die) verbaut. Beispielsweise handelt es sich um ein Halbleiterplättchen samt darauf aufgebrachtem Bauteil, wie beispielsweise einem Transistor, einem Mosfet oder einer Diode.

In einer vorteilhaften Ausführungsform der Erfindung weist das Leistungshalbleitermodul Druckkontaktierungen (buf) für das wenigstens eine Halbleiterelement auf, welche insbesondere als Abstandshalter und/oder Druckstempel ausgestaltet sind. Zusätzlich können auf das Halbleiterelement und/oder auf die Druckkontaktierungen Stressausgleichsschichten aufgebracht werden. Insbesondere sind die Ausgleichsschichten und/oder Abstandshalter, so konzipiert, dass sie die Chips, also die Halbleiterelemente, durch ihre Geometrie mechanisch positionieren. Alternativ oder zusätzlich sind die Ausgleichsschichten und/oder Abstandshalter mit flüchtigen Tacking-Materialien versehen.

Die Druckkontaktierungen (buf) werden mittels wenigstens einer Andrückvorrichtung (sp) über das Gehäuse (h) an das wenigstens eine Halbleiterelement angedrückt werden. Besonders vorteilhaft ist dafür das Gehäuse auf die Druckkontaktierungen angepasst, insbesondere mittels mechanischen Halte- und/oder Führungsvorrichtungen wie beispielsweise Nuten, Mulden, Schienen, Gewinde und/oder Haken.

Insbesondere wird für das Schließen des Gehäuses demnach eine entsprechende Kraft aufgewendet, die für eine ausreichende Druckkraft für eine gute elektrische Kontaktierung sorgt.

In einer alternativen Ausführungsform wird die Vorspannung erst nach dem Schließen des Gehäuses aufgebracht, beispielsweise durch eine intrinsische Verformung des Gehäuses oder von Gehäuseabschnitten, welche insbesondere durch thermische Deformation oder stoffbedingte Schwindung oder Vorspannung realisiert wird. In einer weiteren beispielhaften Ausführungsform erfolgt eine externe Verformung von Gehäuseabschnitten, beispielsweise durch Anziehen außenliegender Verspannschrauben an Gehäuseteilen. Besonders vorteilhaft ist das erfindungsgemäße Leistungshalbleitermodul ausgestaltet, indem wenigstens eine Andrückvorrichtung beispielsweise eine Feder, eine Schraube, einen Bügel und/oder eine Druckausgleichsschicht umfasst.

Das Leistungshalbleitermodul ist zudem so ausgestaltet, dass mittels der Kontaktierungen (buf) ein elektrischer Kontakt zwischen dem wenigstens einen Halbleiterelement (ch HS/LS) und einem Lastanschluss (loa) hergestellt ist.

In einer weiteren vorteilhaften Ausführungsform des erfindungsgemäßen Leistungshalbleitermoduls schließt das Gehäuse (h) die Halbleiterelemente (ch HS/LS) und das Kühlmedium (liq) hermetisch ein.

In einer weiteren vorteilhaften Ausführungsform des erfindungsgemäßen Leistungshalbleitermoduls weist das Gehäuse (h) Dichtungen auf, durch welche Lastanschlüsse (loa) und/oder Gateanschlüsse (G HS/LS) aus dem Gehäuse herausgeführt sind. In einer weiteren beispielhaften Ausgestaltungsform des erfindungsgemäßen Leistungshalbleitermoduls weist das Gehäuse (h) weitere mechanische Verbindungen, insbesondere Nuten und/oder Steckverbindungen auf.

In einer weiteren vorteilhaften Ausführungsform des erfindungsgemäßen Leistungshalbleitermoduls sind die Gehäusewände des Gehäuses (h) so ausgeführt, dass sie im geschlossenen Zustand des Gehäuses (h) einen Kontaktdruck auf Andrückvorrichtung (sp) und Kontaktierungen (buf) ausüben, wie er für die Herstellung der elektrischen Kontakte erforderlich ist. Insbesondere können Strukturen am und/oder im Gehäuse vorgesehen sein, welche zu einer Verstärkung oder Versteifung des Gehäuses führen, um die erforderlichen Druckkräfte aufzubringen zu können.

Zweckdienlicherweise kann das Gehäuse einer der Ausgestaltungsformen des erfindungsgemäßen Leistungshalbleitermoduls wenigstens eine abdichtbare Einfüll- und/oder Ablaufvorrichtung im Gehäuse (h) für das flüssige Kühlmedium (liq) aufweisen. Der Vorteil liegt dabei zunächst darin, dass die Inertflüssigkeit recyclebar ist. Bei einer Öffnung des Gehäuses, ist sogar eine Reparatur des Bauteils möglich. Die gewählte inerte Kühlflüssigkeit muss dabei gewährleisten, dass die Bestandteile des Leistungshalbleitermoduls chemisch nicht angegriffen werden.

In einer beispielhaften Ausgestaltungsform des erfindungsgemäßen Leistungshalbleitermoduls weist wenigstens eine innerhalb des Gehäuses (h) liegende Oberfläche, insbesondere die Oberfläche der Andrückvorrichtung (sp), oder zumindest ein Teil der Gehäuseinnenwand, eine Oberflächenstruktur auf. Dabei handelt es sich besonders vorteilhaft um eine oberflächenvergrößernde Struktur, z.B. Gräben, Stifte oder Rillen, so dass ein besonders effizienter Wärmeübertrag zum oder von dem flüssigen Kühlmedium gewährleistet ist. Diese Ausführungsform birgt den weiteren Vorteil, dass dadurch das effiziente Sieden gefördert wird.

In einer weiteren beispielhaften Ausgestaltungsform des erfindungsgemäßen Leistungshalbleitermoduls weist das Gehäusematerial Materialien aus chemischen Verbindungen auf, welche im Temperaturbereich von -200°C bis 400°C thermisch und chemisch stabil sind.

In einer besonders vorteilhaften Variante der vorbeschriebenen Ausgestaltungsform des erfindungsgemäßen Leistungshalbleitermoduls sind die Gehäusematerialien und/oder Gehäusekomponenten recyclebar. Das heißt, die verwendeten Materialien sind insbesondere Monomaterialien, d.h. keine Verbundwerkstoffe, nicht gefüllt und weisen keine Flammhemmer auf. Auch recyclebare Kunststoffe können eingesetzt werden. Bevorzugt werden metallische Werkstoffe, besonders bevorzugt metallische Monomaterialien verwendet. Diese weisen Vorteile bezüglich mechanischer und thermischer Eigenschaften auf. Des Weiteren wird bevorzugt auf lösbare Verbindungen der Gehäusekomponenten geachtet, welche insbesondere auch Beschriftungen zur Recyclebarkeit aufweisen.

In einer weiteren vorteilhaften Ausführungsform des erfindungsgemäßen Leistungshalbleitermoduls weist dieses eine Vielzahl an Leistungshalbleiterelementen auf, die so in einem Stapel angeordnet sind, dass sie gleichzeitig mittels derselbe(n) Andrückvorrichtung(en) über Kontaktierungen elektrisch kontaktiert sind.

In einer weiteren beispielhaften Ausführungsform des erfindungsgemäßen Leistungshalbleitermoduls weist das Gehäuse Sollbruchstellen und/oder Markierungen für vereinfachtes Öffnen auf.

In einer weiteren besonders vorteilhaften Ausführungsform des erfindungsgemäßen Leistungshalbleitermoduls weist das Gehäuse eine Vorrichtung zur Flüssigkeitsstandüberwachung und/oder zur Temperaturüberwachung auf. Dies können z.B. Sensoren zur Temperatur- und oder Flüssigkeitsstandüberwachung sein.

Der erfindungsgemäße Stromrichter weist zumindest ein erfindungsgemäßes Leistungshalbleitermodul auf. Entsprechend sind auch Anordnungen von mehreren Leistungshalbleitermodulen vorteilhaft. Ein derartiger Stromrichter nutzt vorteilhaft den Modulcharakter aus und ist dadurch in seiner Leistung skalierbar.

Zusammenfassend wird festgehalten, dass die vorgeschlagene Lösung Nachteile insbesondere bezüglich Recyclierbarkeit und Energiebilanz vermeidet:
Es werden möglichst keine stoffschlüssigen, schwer zu trennende Verbindungen mit hochwertigen Materialien wie Loten, Metallen und Halbleitern mehr verwendet oder zumindest deren Anzahl signifikant reduziert.

Der Energieaufwand in der Herstellung wird reduziert, insbesondere im Vergleich zum Energieaufwand in der bisherigen Chip-Herstellung, in DCB-Prozessen, beim Löten, bei thermischen Aushärtungsschritten von Kleber und Silicon-Gelen.

Gleichzeit wird ein neuer Aufbau von Standard-Modulen vorgeschlagen, welcher in Ausführbarkeit und Qualität mit bisherigen Herstellungsprozessen sowie Produkten konkurrieren kann. Die hohe elektrische Isolation, die bisher durch eine Keramik oder ein Silicon-Gel erfolgte, wird durch eine Flüssigkeitsisolierung realisiert. Das gute thermische Management, das bisher durch Lötverbindungen und die Bodenplatte erfolgte, wird nun ebenfalls durch die Flüssigkeitsisolierung sowie die Gehäuseausgestaltung gewährleistet und die erforderliche hohe Zuverlässigkeit der Bauteile wird über materialtechnisch sowie mechanisch ideal abgestimmte kraftschlüssige elektrische Verbindungen realisiert.

Dazu werden ober- und unterseitig druckkontaktierte Chips in ein inertes und isolierendes Kühlmedium eingetaucht und die Verlustwärme der Chips über eine äußere Einhausung abgegeben.

Beispiele und Ausführungsformen der vorliegenden Erfindung werden noch in exemplarischer Weise mit Bezug auf die Figuren 1 bis 6 der angehängten Zeichnung beschrieben:
Fig. 1 zeigt eine Halbbrücken-Schaltungstopologie mit zwei MOSFET-Transistoren.
Fig. 2 zeigt eine Draufsicht auf ein Leistungsmodul, z.B. ein Halbbrücken-Leistungsmodul.
Fig. 3 zeigt die Schnittebene III durch das in Fig. 2 gezeigte Leistungsmodul.
Fig. 4 zeigt die Schnittebene IV durch das in Fig. 2 gezeigte Leistungsmodul.
Fig. 5 zeigt eine Schnittebene durch ein alternativ angeordnetes Leistungsmodul.
Fig. 6 zeigt eine modulare Umrichter-Anordnung.

In den Ausführungsbeispielen und Figuren können gleiche oder gleich wirkende Elemente jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, zur besseren Darstellbarkeit und/oder zum besseren Verständnis im Verhältnis größer dimensioniert dargestellt sein.

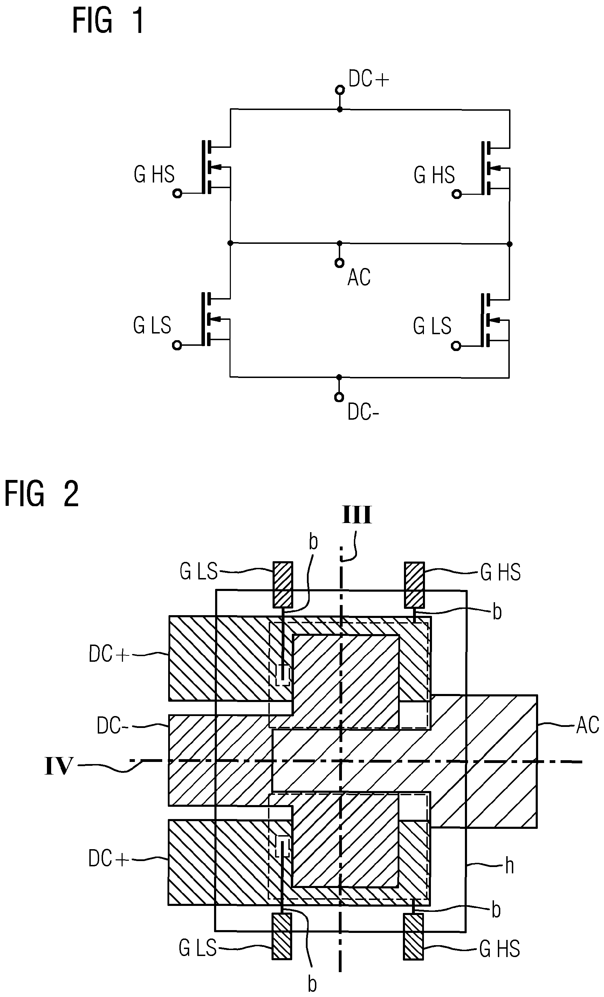

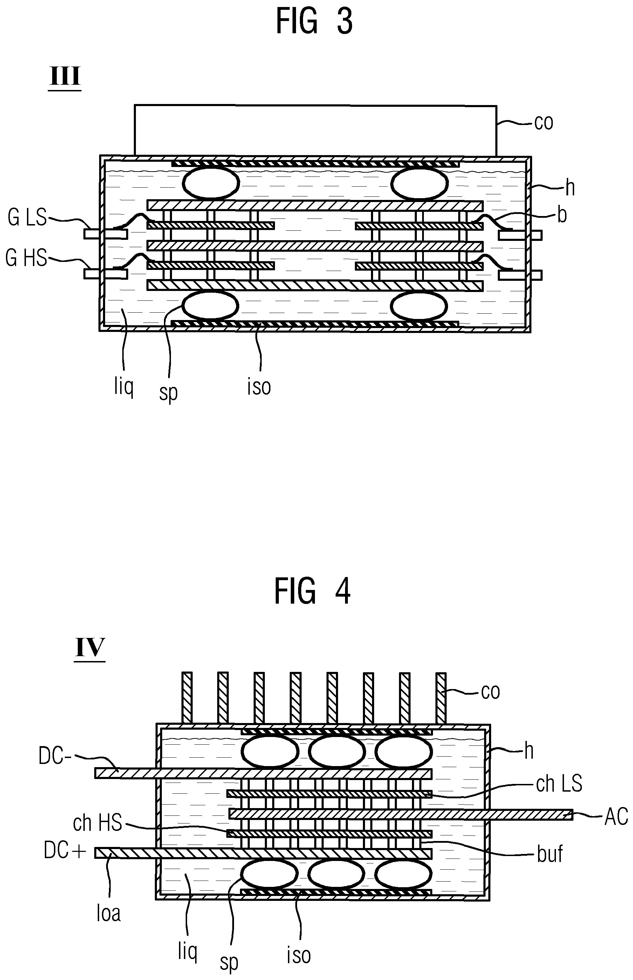

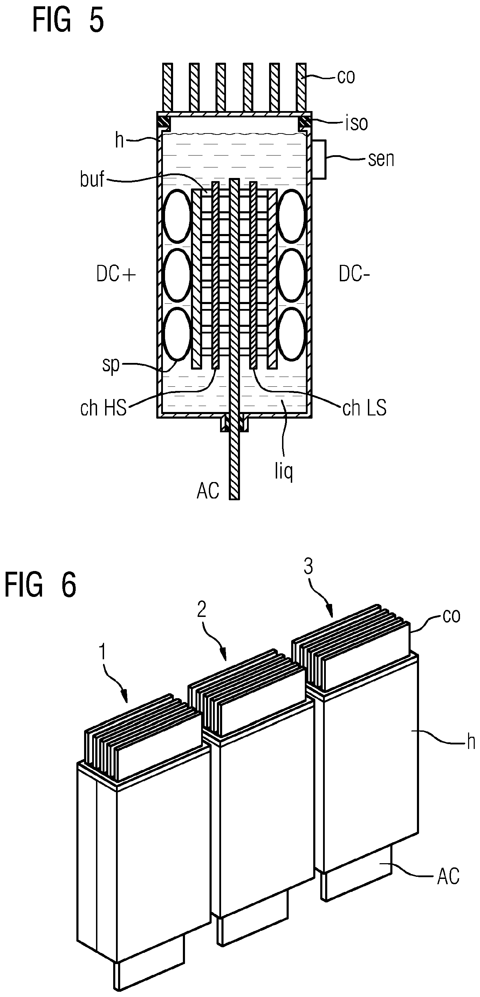

Die Figur 1 zeigt eine Halbbrücken-Schaltungstopologie mit zwei MOSFET-Transistoren entsprechend der Draufsicht auf ein Leistungsmodul, z.B. einen Umrichter, wie in Figur 2 gezeigt. In dieser beispielhaften Ausführungsform eines Leistungsmoduls werden pro topologische Schalter zwei MOSFET-Transistoren verwendet. Dabei steht HS für high side und LS für low side. Die Funktionsweise des in den Figuren 1 und 2 dargestellten Leistungsmoduls beruht darauf, dass sowohl die oberseitige als auch die unterseitige Ankontaktierung der Chips ch HS/LS mithilfe von Druckfedern sp erzeugt wird. Zusätzlich können mehrere Chipebenen übereinander gestapelt und gleichzeitig kontaktiert werden, wie es in den Schnittebenen-Darstellungen III/IV in den Figuren 3 und 4 gezeigt ist. Der gesamte Stapel befindet sich in einer inerten Flüssigkeit liq z.B. 3M Fluorinert, 3M Novec, welche als Isolations- und Kühlmedium fungiert. In der Figur 5 ist eine alternative Hochkant-Anordnung eines Leistungsmoduls gezeigt.

Bei den gezeigten Leistungshalbleitermodulen sind jeweils Halbleiter-Chips ch umfasst, welche mit Stressausgleichsschichten, sogenannten Bufferlayern, und/oder Abstandshaltern buf ausgestattet sind. Zusätzlich oder alternativ können die Chips ch direkt über Druckstempel buf ankontaktiert werden oder sich die Stressausgleichsschichten auf den Druckstempeln befinden.

Die Buffer, Abstandshalter und /oder Druckstempel buf können in unterschiedlichen Geometrien, z.B. säulenförmig oder als zusammenhängende Freiformflächen ausgestaltet sein. Die Buffer, Abstandshalter und /oder Druckstempel buf können unterschiedlich dick sein. Somit ist beispielsweise ein Isolationsabstand einstellbar. Bei Verwendung von Druckstempeln zur direkten Ankontaktierung können diese aus unterschiedlichen elektrisch leitfähigen Materialien ausgeformt sein.

Die Buffer, Abstandshalter und /oder Druckstempel buf können so ausgestaltet sein, dass sie durch ihre Geometrie die Chips ch mechanisch positionieren und/oder mit flüchtigen Tacking-Materialien versehen sind.

Die Buffer, Abstandshalter und /oder Druckstempel buf können stoffschlüssig mit dem Halbleiterelement ch verbunden sein oder auf den Lastanschlüssen loa und/oder Gateanschlüssen G HS/LS ausgeformt vorliegen. Alternativ können sie als eigenständige Schicht zwischen den Halbleiterchips ch und Lastanschlüssen loa angeordnet sein.

Die Buffer, Abstandshalter und /oder Druckstempel buf können einen zum Chip ch angepassten thermischen Ausdehnungskoeffizienten besitzen. Sie können beispielsweise Molybdän oder Verbundwerkstoffe wie CuCNF aufweisen. Alternativ oder zusätzlich können die Buffer, Abstandshalter und /oder Druckstempel buf verformbare feinteilige geometrische Strukturen aufweisen, mittels derer thermischer Stress kompensiert wird.

Zum Beispiel kann durch eine geeignete Vorrichtung sp, wie etwa Federn, Schrauben, Bügel oder eine Druckausgleichsschicht, z.B. aus Silikon, Druck auf die Buffer buf und Chips ch aufgebracht und so der elektrische Kontakt zur Ober- und Unterseite der Chips ch erzeugt werden.

In den Figuren 3 bis 5 ist zudem gezeigt, dass das Leistungsmodul ein Gehäuse h aufweist, welches zur Kühlung und Isolation eine inerte, dielektrische Flüssigkeit liq beinhaltet, in die die druckkontaktierten Chips ch eingetaucht sind. Idealerweise sind alle freien Oberflächen der Druckvorrichtung sp, welche vom Chip ch Wärme aufnehmen und an die dielektrische Flüssigkeit liq abgeben sollen, mit einer Oberflächenstruktur versehen, die auf das effiziente Sieden optimiert ist. So eine Oberflächenstruktur kann z.B. Gräben oder Stifte aufweisen.

Für noch besseres thermisches Management können im chipnahen Aufbau Wärmespreizschichten, insbesondere aus Kupfer oder hochwärmeleitfähigen Verbundwerkstoffen integriert werden. Mittels solcher Wärmespreizschichten wird die zu kühlende Oberfläche im Siedebad vergrößert.

Zweckdienlicherweise kann auch ein Sensor zur Temperatur- und/oder ein Sensor zur Flüssigkeitsstandsüberwachung vorgesehen sein. Das Gehäuse h ist insbesondere so ausgeführt, dass es das Kühlmedium liq und die Chips ch hermetisch einschließt. Dazu ist es bevorzugt mit Hilfe von Dichtungen dicht verschlossen.

Darüber hinaus besteht das Gehäuse überwiegend aus Materialien oder chemischen Verbindungen oder umfasst das Gehäuse überwiegend Materialien oder chemische Verbindungen, die in bestimmten, im Einsatz üblicherweise nicht vorkommenden, Temperaturen und/oder Stoffen löslich sind. Dazu umfasst die Gehäuseoberfläche bevorzugt eine Beschreibung oder Abbildung von Recyclingvorschriften und Materialien auf dem Gehäuse. Diese Beschreibung ist besonders bevorzugt als maschinenlesbarer Code abgedruckt, der auf eine zentral zur Verfügung gestellte Recyclinganleitung verweist.

Das Gehäuse h, kann besonders vorteilhaft auch so ausgestaltet sein, dass es den notwendigen Kontaktdruck ganz oder teilweise aus dem Kontaktdruck der extern angeschlossenen Leiter entnimmt. Beispielsweise wird dazu das Gehäuse h in einen Steckplatz geschoben, wodurch die entsprechende Druckkraft auf die Gehäusehalbschalen ausgeübt wird.

Zudem sind isolierende Teilbereiche iso, z.B. aus Keramik innerhalb des Gehäuses h angeordnet oder im Gehäusematerial vorgesehen. Diese dienen der Trennung von unterschiedlichen elektrischen Potentialen auf den Gehäuseschalen oder zwischen den Lastanschlüssen loa. Das Gehäuse h umfasst zweckdienlicherweise mindestens zwei Gehäuseschalen, die zu einem Gehäuse h zusammengeschlossen werden. An der Berührkante der Gehäuseschalen ist zweckdienlicherweise eine Dichtung vorgesehen. Des Weiteren ist das Gehäuse bevorzugt derart ausgeformt, dass unabhängig von dessen Orientierung beziehungsweise der Orientierung des gesamten Leistungsmoduls, immer gewährleistet ist, dass die Chips ch vollständig mit Flüssigkeit liq bedeckt sind.

Dass die Kühlung und Isolation der druckkontaktierten Schaltung über eine inerte Flüssigkeit liq erfolgt, realisiert eine hoch-effiziente doppelseitige Flüssigkeitstauchkühlung oder eine Siedebadkühlung. Durch die hoch-effiziente Entwärmung wird eine sehr hohe Auslastung der Chips ch ermöglicht. Dadurch wiederum kann Halbleiterfläche und Modulfläche eingespart werden, was wiederum gut für monetäre und ökologische Kosten ist. Die Lebensdauer der Bauteile wird durch die effiziente Kühlung ebenfalls erhöht. Das Gehäuse umfasst beispielsweise auch einen oder mehrere Verschlüsse zum Befüllen und/oder Entleeren des Gehäuses h mit der dielektrischen Flüssigkeit liq. Diese Verschlüsse sind bevorzugt als Schraubverschlüsse ausgeführt und derart abgedichtet, dass die erforderliche Dichtigkeit des Gehäuses nicht herabgesetzt wird.

Direkt an der Gehäuseoberfläche angebrachte Kühlstrukturen co können als Finnen, Pins, Kühlkanäle oder andere oberflächenvergrößernde Strukturen zum Abführen der Verlustwärme vom Modul ausgeführt sein. Die Verlustwärme wird also über das Gehäuse h an ein durchgeführtes oder äußerlich kontaktierendes Medium abgeführt. Dadurch wird ein einfacher Wärmeabtransport im Umrichter ohne zusätzliche Wärmeübergänge geschaffen. Durch Vermeidung solcher Wärmeübergänge werden vorteilhaft Wärmeleitpaste eingespart beziehungsweise vermieden, großen und teuren Kühlkörpern überflüssig und es ist eine Modularisierbarkeit und Skalierbarkeit des Leistungsteils beispielsweise in einem Umrichter möglich.

Besonders vorteilhaft für die Recyclierbarkeit ist eine beispielhafte Ausgestaltung des Gehäuses h mit Sollbruchstellen und/oder Markierungen, an denen ein einfaches Öffnen des Gehäuses h möglich ist. Soll das Bauteil zerlegt und entsorgt werden, können so möglichst unaufwendig und schnell die Einzelkomponenten entnommen werde. Soll das Bauteil repariert werden, gewährleistet die leichte Zugänglichkeit, dass es durch das Öffnen des Gehäuses h nicht zu weiteren, nicht-reparierbaren Schäden an den Einzelkomponenten, insbesondere den Halbleiterchips ch kommt. Eine derartige leichtere Gehäuseöffnung für möglichst leichten Zugang zu den inneren Bauteilen kann beispielsweise dadurch erwirkt werden, dass Gehäusestrukturen eingearbeitet sind, die beim Befestigen des Moduls gezielt brechen, das Gehäuse h dabei jedoch nicht öffnen oder in seiner Funktion bezüglich Dichtigkeit und Anpressdruck für die Druckkontaktierung beeinträchtigen. Das Modul ist dann nach der "ersten Lebensdauer" durch die gezielte Vorschädigung leichter zu demontieren und zu zerlegen. Gleichzeitig oder alternativ kann das Gehäuse h Strukturen, umfassen, welche zu einer erhöhten Versteifung des Gehäuses führen, welche bewirkt, dass die für die Druckkontaktierung erforderlichen Druckkräfte aufgebracht werden können.

Die im Gehäuse h befindlichen und somit in der dielektrischen Flüssigkeiten liq eingetauchten elektrischen Leiteranordnungen, wie beispielsweise Gateanschlüsse G LS/HS oder Lastanschlüsse loa wie AC-Anschluss, DC+ Anschluss oder DC- Anschluss eines Transistors können in besonders vorteilhafter Ausgestaltung der Anordnung Durchlässe aufweisen, beispielsweise sind sie perforiert, so dass sie durchlässig für Querströmungen der dielektrischen Flüssigkeit liq sind. Dies verbessert weiter das Thermomanagement. Der Wärmeabtransport wird begünstigt und gleichzeitig erfolgt eine Oberflächenvergrößerung der zu entwärmenden Bauteile.

Zur Kontaktierung der Gate-Strukturen G LS/HS oder für den Potentialabgriff auf der Chipober- und Unterseite ch können Drahtbonds aber bevorzugt auch dafür gesondert angeordnete Druckkontakte vorgesehen sein. Diese können insbesondere als Federkontaktstifte ausgebildet sein.

Wie in den Figuren 3 bis 5 gut erkennbar ist, können mehrere Chips ch in einer gestapelten Anordnung gleichzeitig über Druckkräfte kontaktiert werden. Hier sind auch noch mehr Lagen Halbleiterelemente ch möglich als in den Figuren gezeigt.

Der Leistungsmodulaufbau aus hermetisch dichtem Gehäuse und Flüssigkeitskühlung und -isolation umfassend kann alternativ aber auch Halbleiterchips ch umfassen, welche lediglich einseitig über Druckkräfte ankontaktiert werden und deren zweite Seite sich konventionell auf einer DCB oder Leiterplatte befindet. Ein wichtiger Vorteil des vorgeschlagenen Leistungshalbleitermodulaufbaus liegt aber darin, dass möglichst viele bis alle elektrischen Kontakte im Bauteil, aber insbesondere die Ankontaktierung der Leistungselektronik-Chips ein- oder beidseitig über Druckkräfte und ohne stoffschlüssige Verbindung erfolgt. Dies ermöglicht ein einfaches Zerlegen zur Reparatur, zum Refurbishing oder zum Recycling. Es werden Materialien, zum Beispiel Lotmaterialien, und energieintensive Herstellungsprozesse eingespart. Ein besonders vorteilhafter mehrlagiger, nieder-induktiver Aufbau wird möglich. Die Druckkontakte weisen eine erhöhte Lebensdauer auf was zu einer Erhöhung der Gesamtlebensdauer der Bauteile beiträgt.

Figur 6 zeigt eine modulare Umrichter-Anordnung. Dazu wird eine modulare Anordnung mehrerer Teil-Leistungsmodulzellen miteinander verschalten, vergleichbar zu Batteriezellen. Daraus ist ein in seiner Leistung skalierbarer Umrichter realisierbar. Generell ist ein einfacher Systemaufbau und eine einfache Montage möglich. Alternativ können beispielsweise Modul-Batterien in Federkontakte, also Druckkontakte, eingeschoben und so elektrisch kontaktiert werden.

Die vorgeschlagene Technologie bietet also die Möglichkeit ein Leistungsmodul mit einem sehr geringen Anteil an stoffschlüssigen Verbindungen sowie einem insgesamt reduzierten Material- und Energieaufwand herzustellen. Die Herstellung erfolgt bei gleichzeitigem Aufrechterhalten einer hohen elektrischen Isolation und darüber hinaus einer stark verbesserten Kühlung der Halbleiterchips. Durch eine Minimierung der stoffschlüssigen Verbindungen im Leistungsmodul in Bezug auf ihre Anzahl und ihre Massen- und Volumenanteile insgesamt, wird ein Modul geschaffen, welches sehr einfach in seine einzelnen Bestandteile zerlegt werden kann und dadurch eine sehr gute Recycling- und Reparaturfähigkeit aufweist.

Zusätzlich dazu wird es durch einen gestapelten 3d-Aufbau möglich, Leistungsmodule mit einer nahezu idealen, sehr niedrigen Induktivität zu realisieren. Durch einen gestapelten Aufbau ist es möglich die Chips elektrisch vorteilhaft anzuordnen. Infolgedessen können die Chips schneller geschaltet und zusätzlich durch die gute Kühlung effizienter ausgenutzt werden.

### Bezugszeichenliste

- G HS: Gate high side
- G LS: Gate low side
- AC: AC Anschluss
- DC+: DC+ Anschluss
- DC-: DC- Anschluss
- A: Schnitt A
- B: Schnitt B
- b: Bonddraht
- h: hermetisches Gehäuse
- buf: Stressbuffer
- liq: Inertflüssigkeit
- iso: Isolation
- sp: Federn
- loa: Lastanschluss
- ch HS: Chips HS
- ch LS: Chips LS
- co: Kühlrippen
- sen: Sensor

## Patentansprüche

1. Leistungshalbleitermodul,
aufweisend wenigstens ein Leistungshalbleiterelement (ch HS/LS) in einem Gehäuse (h),
wobei das Gehäuse (h) wenigstens ein flüssiges Kühlmedium (liq) beinhaltet,
wobei Gehäuse (h) und Leistungshalbleiterelement (ch HS/LS) über das Kühlmedium (liq) in einer thermisch leitfähigen Verbindung stehen,
wobei das Kühlmedium (liq) insbesondere eine dielektrische Flüssigkeit ist,
wobei das Leistungshalbleitermodul Druckkontaktierungen (buf) für das wenigstens eine Halbleiterelement (ch HS/LS) umfasst, welche mittels wenigstens einer Andrückvorrichtung (sp) an das wenigstens eine Halbleiterelement (ch HS/LS) angedrückt werden, so dass ein elektrischer Kontakt hergestellt ist, und
wobei das Gehäuse (h) ausgestaltet ist, die Druckkontaktierungen (buf) mittels wenigstens einer Andrückvorrichtung (sp) kraftschlüssig mit wenigstens einem Leistungshalbleiterelement zu verbinden, und
wobei mittels der Druckkontaktierungen (buf) ein elektrischer Kontakt zwischen dem wenigstens einen Halbleiterelement (ch HS/LS) und einem Lastanschluss (loa) hergestellt ist.

2. Leistungshalbleitermodul nach Anspruch 1, wobei die Druckkontaktierungen (buf) für das wenigstens eine Halbleiterelement (ch HS/LS) als Stressausgleichsschichten, Abstandshalter oder Druckstempel ausgestaltet sind.

3. Leistungshalbleitermodul nach Anspruch 2, wobei die wenigstens eine Andrückvorrichtung (sp) insbesondere eine Feder, eine Schraube, einen Bügel oder eine Druckausgleichsschicht umfasst.

4. Leistungshalbleitermodul nach einem der vorstehenden Ansprüche, wobei das Gehäuse (h) die Halbleiterelemente (ch HS/LS) und das Kühlmedium (liq) hermetisch einschließt.

5. Leistungshalbleitermodul nach Anspruch 4, bei dem das Gehäuse (h) Dichtungen aufweist, durch welche Lastanschlüsse (loa) und/oder Gateanschlüsse (G HS/LS) herausgeführt sind.

6. Leistungshalbleitermodul nach einem der vorstehenden Ansprüche, wobei die Gehäusewände des Gehäuses (h) so ausgeführt ist, dass sie im geschlossenen Zustand des Gehäuses (h) einen Kontaktdruck auf Andrückvorrichtung (sp) und Kontaktierungen (buf) ausüben, wie er für die Herstellung der elektrischen Kontakte erforderlich ist.

7. Leistungshalbleitermodul nach einem der vorstehenden Ansprüche mit wenigstens einer abdichtbaren Einfüll- und/oder Ablaufvorrichtung im Gehäuse (h) für das flüssige Kühlmedium (liq).

8. Leistungshalbleitermodul nach einem der vorstehenden Ansprüche, wobei wenigstens eine innerhalb des Gehäuses (h) liegende Oberfläche, insbesondere die Oberfläche der Andrückvorrichtung (sp), oder zumindest ein Teil der Gehäuseinnenwand, eine Oberflächenstruktur aufweist, insbesondere Gräben, Stifte, Rillen, dass ein besonders effizienter Wärmeübertrag zum oder von dem flüssigen Kühlmedium gewährleistet ist.

9. Leistungshalbleitermodul nach einem der vorstehenden Ansprüche, wobei das Gehäuse (h) Verbindungen aufweist, welche in einem Temperaturbereich von -200°C bis 400°C thermisch und chemisch stabil sind.

10. Leistungshalbleitermodul nach Anspruch 9, wobei die Gehäuseverbindungen recyclebar sind.

11. Leistungshalbleitermodul nach einem der vorstehenden Ansprüche, welches eine Vielzahl an Halbleiterelementen (ch) umfasst, die so in einem Stapel angeordnet sind, dass sie gleichzeitig mittels derselbe(n) Andrückvorrichtung(en) (sp) über Kontaktierungen (buf) elektrisch kontaktiert sind.

12. Leistungshalbleitermodul nach einem der vorstehenden Ansprüche, wobei das Gehäuse (h) Sollbruchstellen und/oder Markierungen für vereinfachtes Öffnen aufweist.

13. Leistungshalbleitermodul nach einem der vorstehenden Ansprüche, wobei das Gehäuse (h) eine Vorrichtung zur Flüssigkeitsstandüberwachung und/oder zur Temperaturüberwachung (sen) aufweist.

14. Stromrichter mit mindestens einem Leistungshalbleitermodul nach einem der vorherigen Ansprüche.

## Claims

1. Power semiconductor module
having at least one power semiconductor element (ch HS/LS) in a housing (h),
wherein the housing (h) contains at least one liquid cooling medium (liq),
wherein the housing (h) and power semiconductor element (ch HS/LS) are thermally conductively connected via the cooling medium (liq),
wherein the cooling medium (liq) is in particular a dielectric liquid,
wherein the power semiconductor module comprises pressure contacts (buf) for the at least one semiconductor element (ch HS/LS), said pressure contacts being pressed by means of at least one pressing apparatus (sp) against the at least one semiconductor element (ch HS/LS) such that electrical contact is established, and
wherein the housing (h) is embodied to connect the pressure contacts (buf) in a force-fitting manner by means of at least one pressing apparatus (sp) to at least one power semiconductor element, and
wherein an electrical contact is established between the at least one semiconductor element (ch HS/LS) and a load terminal (loa) by means of the pressure contacts (buf).

2. Power semiconductor module according to claim 1, wherein the pressure contacts (buf) for the at least one semiconductor element (ch HS/LS) are embodied as stress compensation layers, spacers or pressure rams.

3. Power semiconductor module according to claim 2, wherein the at least one pressing apparatus (sp) in particular comprises a spring, a screw, a bracket or a pressure compensation layer.

4. Power semiconductor module according to one of the preceding claims, wherein the housing (h) hermetically encloses the semiconductor elements (ch HS/LS) and the cooling medium (liq).

5. Power semiconductor module according to claim 4, wherein the housing (h) has seals through which load terminals (loa) and/or gate terminals (G HS/LS) are led out.

6. Power semiconductor module according to one of the preceding claims, wherein the housing walls of the housing (h) are embodied such that, when the housing (h) is closed, they exert a contact pressure on the pressing apparatus (sp) and contacts (buf) as required for establishing the electrical contacts.

7. Power semiconductor module according to one of the preceding claims with at least one sealable filling and/or draining apparatus in the housing (h) for the liquid cooling medium (liq).

8. Power semiconductor module according to one of the preceding claims, wherein at least one surface lying within the housing (h), in particular the surface of the pressing apparatus (sp), or at least part of the inner wall of the housing, has a surface structure, in particular trenches, pins, grooves, to ensure particularly efficient heat transfer to or from the liquid cooling medium.

9. Power semiconductor module according to one of the preceding claims, wherein the housing (h) has connections which are thermally and chemically stable in a temperature range of -200°C to 400°C.

10. Power semiconductor module according to claim 9, wherein the housing compounds are recyclable.

11. Power semiconductor module according to one of the preceding claims comprising a plurality of semiconductor elements (ch) arranged in a stack such that they are simultaneously electrically contacted by means of the same pressing apparatus(es) (sp) via contacts (buf).

12. Power semiconductor module according to one of the preceding claims, wherein the housing (h) has predetermined breaking points and/or markings for simplified opening.

13. Power semiconductor module according to one of the preceding claims, wherein the housing (h) has an apparatus for liquid level monitoring and/or for temperature monitoring (sen).

14. Power converter having at least one power semiconductor module according to one of the preceding claims.

## Revendications

1. Module de puissance à semiconducteur,
comportant au moins un élément (ch HS/LS) de puissance à semiconducteur dans un boîtier (h),
dans lequel le boîtier (h) contient au moins un fluide (liq) de refroidissement liquide,
dans lequel le boîtier (h) et l'élément (ch HS/LS) de puissance à semiconducteur sont en une liaison de conduction thermique par le fluide (liq) de refroidissement,
dans lequel le fluide (liq) de refroidissement est en particulier un liquide diélectrique,
dans lequel le module de puissance à semiconducteur comprend des mises (buf) en contact par pression pour le au moins un élément (ch HS/LS) à semiconducteur, lesquelles sont, au moyen d'un dispositif (sp) d'application d'une pression, appliquées avec pression sur le au moins un élément (ch HS/LS) à semiconducteur, de manière à produire un contact électrique, et
dans lequel le boîtier (h) est conformé pour relier les mises (buf) en contact avec pression, au moyen d'au moins un dispositif (sp) d'application d'une pression à coopération de force, à au moins un élément de puissance à semiconducteur, et
dans lequel, au moyen des mises (buf) en contact avec pression, un contact électrique entre le moins un élément (ch HS/LS) à semiconducteur et une borne (loa) de charge est produit.

2. Module de puissance à semiconducteur suivant la revendication 1, dans lequel les mises (buf) en contact avec pression pour le au moins un élément (ch HS/LS) à semiconducteur sont conformées en couches de compensation de contrainte, en entretoise ou en poinçon d'application d'une pression.

3. Module de puissance à semiconducteur suivant la revendication 2, dans lequel le au moins un dispositif d'application d'une pression comprend en particulier un ressort, une vis, un étrier ou une couche de compensation de la pression.

4. Module de puissance à semiconducteur suivant l'une des revendications précédentes, dans lequel le boîtier (h) enferme hermétiquement les éléments (ch HS/LS) à semiconducteur et le fluide (liq) réfrigérant.

5. Module de puissance à semiconducteur suivant la revendication 4, dans lequel le boîtier (h) a des garnitures d'étanchéité, par lesquelles sortent des bornes (loa) de charge et/ou des bornes (G HS/LS) de grille.

6. Module de puissance à semiconducteur suivant l'une des revendications précédentes, dans lequel les parois du boîtier (h) sont réalisées de manière à appliquer, lorsque le boîtier (h) est à l'état fermé, une pression de contact sur le dispositif (sp) d'application d'une pression et sur les mises (buf) en contact comme cela est nécessaire pour la production des contacts électriques.

7. Module de puissance à semiconducteur suivant l'une des revendications précédentes, comprenant au moins un dispositif de remplissage et/ou d'évacuation, pouvant être rendu étanche, dans le boîtier (h) pour le fluide (liq) réfrigérant liquide.

8. Module de puissance à semiconducteur suivant l'une des revendications précédentes, dans lequel au moins une surface se trouvant à l'intérieur du boîtier (h), en particulier la surface du dispositif (sp) d'application d'une pression ou au moins une partie de la paroi intérieure du boîtier a une structure superficielle, en particulier des sillons, des ergots, des rainures, en ce qu'une transmission particulièrement efficace de la chaleur au ou du fluide réfrigérant liquide est assurée.

9. Module de puissance à semiconducteur suivant l'une des revendications précédentes, dans lequel le boîtier (h) a des liaisons, qui sont stables thermiquement et chimiquement dans une plage de températures de - 200°C à 400°C.

10. Module de puissance à semiconducteur suivant la revendication 9, dans lequel les liaisons du boîtier sont recyclables.

11. Module de puissance à semiconducteur suivant l'une des revendications précédentes, qui comprend une pluralité d'éléments (ch) à semiconducteur, qui sont disposés en une pile, de manière à ce qu'ils soient en même temps, au moyen du ou des mêmes dispositifs (sp) d'application d'une pression, mis en contact électrique par leurs mises (buf) en contact.

12. Module de puissance à semiconducteur suivant l'une des revendications précédentes, dans lequel le boîtier (h) a des points destinés à se rompre et/ou des repères pour simplifier l'ouverture.

13. Module de puissance à semiconducteur suivant l'une des revendications précédentes, dans lequel le boîtier (h) a un dispositif de contrôle du niveau du liquide et/ou de contrôle (sen) de la température.

14. Convertisseur comprenant au moins un module de puissance à semiconducteur suivant l'une des revendications précédentes.
